Europäisches Patentamt

European Patent Office

Office européen des brevets

(11) Numéro de publication: **0 228 316**
A1

# DEMANDE DE BREVET EUROPEEN

(21) Numéro de dépôt: 86402481.5

(22) Date de dépôt: 06.11.86

(51) Int. Cl.4: **H 01 L 21/84**
H 01 L 29/78

(30) Priorité: 15.11.85 FR 8516921

(43) Date de publication de la demande:
08.07.87 Bulletin 87/28

(84) Etats contractants désignés:
CH DE FR GB IT LI NL

(71) Demandeur: **COMMISSARIAT A L'ENERGIE ATOMIQUE**
**31/33, rue de la Fédération**
**F-75015 Paris (FR)**

(72) Inventeur: **Diem, Bernard**
**63, rue des Aiguinards**
**F-38240 Meylan (FR)**

(74) Mandataire: **Mongrédien, André et al**
**c/o BREVATOME 25, rue de Ponthieu**
**F-75008 Paris (FR)**

(54) **Procédé de fabrication d'un transistor en couches minces et transistor obtenu.**

(57) Procédé de fabrication d'un transistor en couches minces à grille auto-alignée par rapport au drain et à la source de celui-ci.

Le procédé consiste à réaliser sur un substrat (2) la grille (4) du transistor ; à déposer sur le substrat et la grille une couche d'isolant (6) ; à déposer sur la couche d'isolant une première couche de silicium amorphe hydrogéné (8) ; à déposer sur la première couche de silicium une seconde couche de silicium amorphe hydrogéné de type n+ (10) et à réaliser la source et le drain du transistor.

Application à la réalisation de matrices actives pour écrans plats à cristaux liquides.

FIG. 1

## Description

PROCEDE DE FABRICATION D'UN TRANSISTOR EN COUCHES MINCES TRANSISTOR OBTENU.

La présente invention a pour objet un procédé de fabrication d'un transistor en couches minces à grille auto-alignée par rapport au drain et à la source et partiellement recouverte par ceux-ci.

D'une façon générale, elle permet la fabrication des composants semi-conducteurs en couches minces pouvant servir au multiplexage de tels composants disposés sous forme matricielle, ainsi qu'à la réalisation de dispositifs à transfert de charge (DTC en abrégé).

Plus particulièrement, elle permet la fabrication de transistors en couches minces pouvant servir en optoélectronique à la réalisation de matrices actives pour les écrans plats à cristaux liquides, c'est-à-dire ayant des surfaces de plusieurs dm$^2$ avec un bon rendement de fabrication.

On connaît déjà bon nombre de procédés de fabrication de transistors en couches minces (TCM en abrégé), pour lesquels deux types de techniques sont essentiellement utilisés : la technique "grille dessus" où la grille est réalisée en dernier sur la structure semi-conductrice et la technique "grille dessous" où la grille est réalisée en premier sur le substrat.

La première technique, décrite par OKADA et al. et publiée dans "Electronics Letters" 21, N° 15, p.633, utilise un procédé microélectronique du silicium monocristallin pour l'implantation ionique. Malheureusement, cette technique est trop lourde pour la réalisation de TCM destinés à être utilisés dans la fabrication d'écrans d'affichage plat à grande surface.

La publication du brevet français FR-A-2 553 579 et intitulé "Procédé de fabrication d'un transistor en film mince à grille auto-alignée" illustre la seconde technique qui offre les meilleures caractéristiques pour la fabrication de composants servant à la réalisation de matrices actives pour les écrans plats à cristaux liquides.

Dans ce procédé de fabrication de TCM, les phases d'irradiation et de développement de la résine sont suivies d'un dépôt d'une couche de silicium amorphe hydrogéné de type n+ effectué à une température basse, de l'ordre de 120°C pour ne pas provoquer un fluage trop important de la couche de résine, laquelle sert de masque au dépôt. Mais, ce dépôt à basse température a l'inconvénient de conduire à un matériau et une interface silicium amorphe hydrogéné/silicium amorphe hydrogéné de type n+, de mauvaise qualité. Pour une qualité de de semi conducteur déterminée, les caractéristiques des transistors à effet de champ dépendent de la qualité de cette interface ainsi que de celle des contacts établis sur les électrodes de drain et de source.

L'Homme de l'Art sait résoudre le premier des deux problèmes précédents en déposant les couches de silicium amorphe et de SiO$_2$ dans une même étape sous vide, comme l'indique le document IEE Electron Device Letters, Vol. EDL 3, July 1982, n° 7, New-York, p. 187 et suivantes. Cette publication ne vise pas toutefois la réalisation de structures de transistors auto alignée et ne permet pas la solution du second problème précédent.

La présente invention a justement pour objet un procédé de fabrication d'un TCM permettant de remédier à ces inconvénients. Elle utilise la technique "grille dessous" et permet notamment de réaliser des matériaux et des interfaces isolant/première couche de silicium et première couche de silicium/seconde couche de silicium de qualité supérieure à celle des matériaux obtenus par les techniques précédentes.

De façon plus précise, l'invention a pour objet un procédé de fabrication d'un transistor en cou ches minces à grille auto-alignée par rapport au drain et à la source de celui-ci comprenant dans l'ordre les étapes de :
- réalisation sur un substrat de la grille du transistor,
- dépôt dans une même étape sous vide,
- d'une couche d'isolant sur le substrat et la grille,
- d'une première couche de silicium amorphe hydrogéné sur la couche d'isolant,
- d'une seconde couche de silicium amorphe hydrogéné de type n+ sur la première couche de silicium, caractérisée en ce que l'on recouvre ensuite l'ensemble d'une résine photosensible que l'on grave, au travers de la grille, en retrait de cette grille, pour réaliser le drain et la source du transistor, avec un léger recouvrement par rapport à la grille.

La présente invention a également pour objet un transistor en couches minces à grille auto-alignée et à effet de champ à deux couches de silicium amorphes hydrogénées, caractérisé en ce qu'il comporte une zone de recouvrement de la grille par les électrodes de source et de drain.

De façon avantageuse, la première couche de silicium amorphe hydrogéné présente une épaisseur inférieure ou égale à 100 nm.

Les résistances d'accès du transistor, préjudiciables au fonctionnement des TCM réalisés dans du sicilium amorphe hydrogéné parce qu'elles introduisent une augmentation du temps de réponse du composant et une diminution du courant "on", varient de façon connue d'une part comme l'épaisseur de la couche de silicium à la puissance 3 et, d'autre part, comme la surface de recouvrement de la gille du TCM par les électrodes du drain et de la source de celui-ci.

L'utilisation, selon l'invention, d'une épaisseur de couche de silicium amorphe hydrogéné, environ trois fois plus mince que dans une structure classique (100 nm selon l'invention au lieu de 300 nm classiquement) réduit par conséquent le recouvrement nécessaire de la grille du TCM par rapport à la source et au drain de celui-ci, d'un facteur égal à 27 (3$^3$) sans altérer les performances du TCM.

Selon l'invention, l'irradiation homogène à travers le substrat, la grille servant de masque à ladite irradiation est conduite à un niveau tel que l'on obtienne, lors du développement, un léger décrochement de cette résine par rapport au droit de la grille ; de préférence ce décrochement a une largeur proportionnelle à la longueur d'onde de l'irradiation divisée par deux, soit selon un exemple préférentiel de l'invention 0,45 μm/2 = 0,225 μm.

Ce léger décrochement est le siège du recouvrement ultérieur de la grille du TCM par la source et le drain de celui-ci et assure la qualité des contacts de ces deux électrodes, puisque ceux-ci se situent ainsi dans la zone de conduction déterminée par l'effet de champ de la grille.

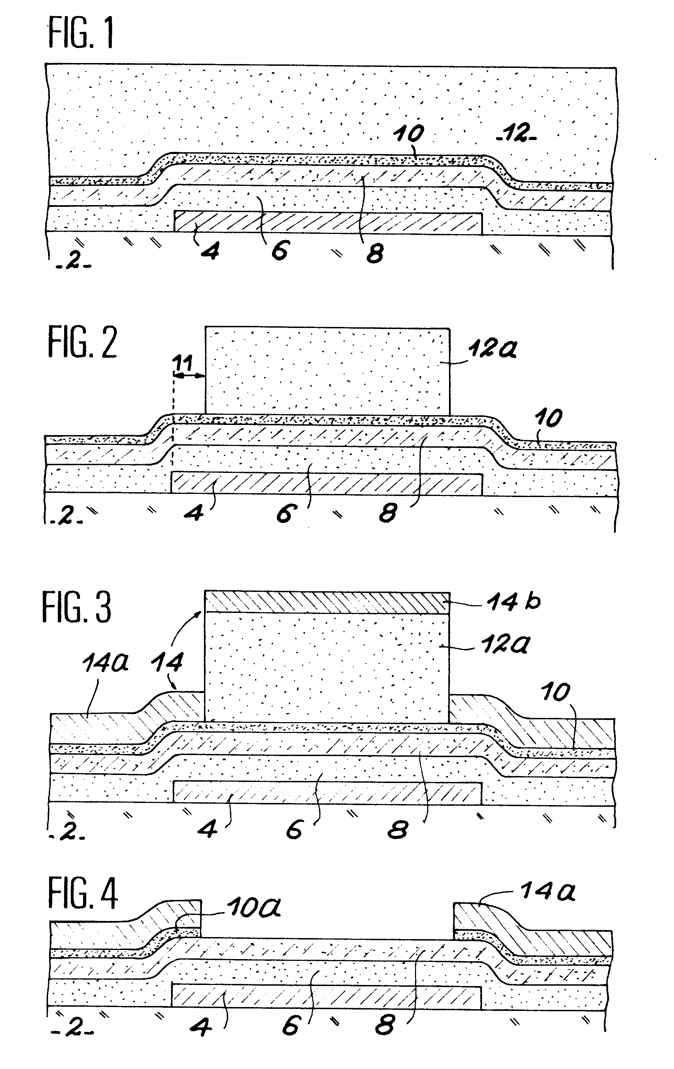

D'autres caractéristiques et avantages de l'invention ressortiront mieux de la description qui va suivre, donnée à titre illustratif mais non limitatif, en référence aux figures 1 à 4 annexées, qui illustrent les différentes étapes du procédé selon l'invention.

Comme représenté sur la figure 1, la première étape du procédé consiste à réaliser, sur un substrat en verre 2, la grille 4 du transistor en utilisant les procédés classiques de la photolithographie sous vide (masquage et gravure). Cette grille 4, présentant par exemple une épaisseur de 100 nm, est réalisée de préférence en chrome. On dépose ensuite, sur le substrat 2 et la grille 4 du transistor, une couche d'isolant 6, réalisée de préférence en oxyde de silicium. Cette couche d'isolant présentant par exemple une épaisseur de 120 nm peut être obtenue par la technique de dépôt chimique en phase vapeur, à basse pression ou non, ou bien par la technique de décharge luminescente, dans un appareil à radiofréquence, en utilisant un mélange gazeux de SiH$_4$ et de O$_2$. Toutefois, quelle que soit la technique utilisée, la température de dépôt est de préférence de l'ordre de 300°C.

On dépose ensuite et dans le même vide, sur la couche d'isolant 6, une couche de silicium amorphe hydrogéné 8 présentant avantageusement une épaisseur variant de 50 nm à 100 nm. De préférence, l'épaisseur de la couche de silicium est voisine de 80 nm et la température de dépôt de l'ordre de 300°C. Cette couche de silicium peut être obtenue par la technique de décharge luminescente en utilisant le gaz SiH$_4$.

Sur l'ensemble de la structure, on dépose ensuite et dans le même vide, une couche de silicium amorphe 10 de type n+, hydrogéné ou non, présentant par exemple une épaisseur de 15 nm. Cette couche de silicium 10, déposée par la même technique et dans les mêmes conditions de dépôt que le silicium amorphe hydrogéné, permet la réalisation de contacts ohmiques pour la source et le drain du TCM.

L'étape suivante du procédé consiste à déposer, sur la couche de silicium amorphe hydrogéné de type n+ 10, une couche de résine photosensible positive 12, sensible à la lumière ayant une longueur d'onde de l'ordre de 450 nm. Cette couche de résine peut être notamment déposée par centrifugation. Comme résine, on peut utiliser des résines à base de phénolformaldéhyde comme celle vendue par la Société HUNT sous la référence HPR 204.

Comme représenté sur la figure 2, la couche de résine photosensible 12 est ensuite irradiée à travers le substrat 2, la grille 4 servant alors de masque à l'irradiation. L'utilisation d'une résine sensible dans le visible permet de diminuer la durée de l'irradiation. Le développement de la couche de résine permet de ne garder de cette couche que la zone 12a, située légèrement en retrait de la grille du transistor, les zones irradiées étant éliminées .

Le retrait de la résine, ne se fait pas au droit de la grille mais avec un léger décrochement 11 que l'on obtient par une surinsolation contrôlée à l'aide d'un photodétecteur. On le choisit, de largeur proportionnelle, de façon connue, à la longueur d'onde de l'irradiation divisée par 2, soit dans l'exemple décrit, une largeur de l'ordre de 0,225 μm.

Ce léger décrochement 11 est le siège du recouvrement ultérieur de la grille du TCM par la source et le drain de celui-ci et constitue l'avantage essentiel du procédé objet de la présente invention en permettant de placer les électrodes de drain et de source dans la zone de conduction du transistor, au-dessus de la grille.

A titre indicatif une valeur optimale de ce retrait de la résine est de 0,2 à 0,4 μm pour une couche 10 de silicium amorphe hydrogéné de 1000 angströms.

Comme représenté sur la figure 3, on dépose ensuite sur l'ensemble de la structure une couche conductrice 14, présentant par exemple une épaisseur de 150 nm, et obtenue par dépôt, par exemple par évaporation sous vide ou par pulvérisation cathodique. La couche conductrice 14 est décomposée en deux parties : la première partie 14a recouvrant la seconde couche de silicium 10 non occupée par la résine restante 12a et la seconde partie 14b recouvrant la résine restante 12a.

Comme représenté sur la figure 4, au moyen de la technique connue sous l'expression anglo-saxonne "lift-off", on élimine la résine restante 12a et la couche conductrice 14b déposée sur cette dernière.

On réalise, dans la couche conductrice restante 14a, les électrodes de la source et du drain du transistor par les procédés classiques de photolithographie (masquage et gravure).

On grave ensuite la couche de silicium amorphe hydrogéné de type n+ jusqu'à mise à nu de la couche de silicium amorphe hydrogéné par ces mêmes procédés de photolithographie où le masque de la gravure est ici défini par les électrodes du drain et de la source du TCM. De cette gravure, qui attaque chimiquement la seconde couche de silicium située dans le canal du TCM, il ne reste qu'une couche de silicium 10a.

Le procédé décrit précédemment permet d'aligner la grille par rapport à la source et au drain du transistor ; mais il ne permet pas d'obtenir une structure électriquement coplanaire comme celle obtenue dans les transistors MOS, dans laquelle le canal du transistor et les électrodes du drain et de la source sont situés dans le même plan.

L'emploi d'une couche de silicium amorphe hydrogéné mince permet toutefois de réduire les résistances d'accès du transistor. Enfin, le procédé de l'invention améliore la qualité des matériaux déposés et ne présente pas d'étapes critiques.

## Revendications

1. Procédé de fabrication d'un transistor en couches minces à grille auto-alignée par rapport au drain et à la source de celui-ci comprenant dans l'ordre les étapes de
- réalisation sur un substrat de la grille du transistor,
- dépôt dans une même étape sous vide :
- d'une couche d'isolant sur le stubstrat et de la grille,
- d'une première couche de silicium amorphe hydrogéné sur la couche d'isolant,
- d'une seconde couche de silicium amorphe hydrogéné de type n+ sur la première couche de silicium, caractérisé en ce que l'on recouvre ensuite l'ensemble d'une résine photosensible que l'on grave, au travers de la grille, en retrait de cette grille, pour réaliser le drain et la source du transistor, avec un léger recouvrement par rapport à la grille.

2. Procédé de fabrication selon la revendication 1, caractérisé en ce que l'épaisseur de la première couche de silicium amorphe hydrogéné (8) est de 50 à 100 nanomètres.

3. Transistor en couches minces à grille auto-alignée et à effet de champ à deux couches de silicium amorphe hydrogéne, caractérisé en ce qu'il comporte une zone de recouvrement de la grille par les électrodes de source et de drain.

4. Transistor selon la revendication 3, caractérisé en ce que cette zone de recouvrement est de 0,2 à 0,4 µm pour une seconde couche de silicium hydrogéné de 1000 angströms.

0228316

FIG. 1

FIG. 2

FIG. 3

FIG. 4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | IEEE TRANSACTIONS ON ELECTRON DEVICES, vol. ED-30, no. 5, mai 1983, pages 525-532, IEEE, New York, US; A.I. LAKATOS: "Promise and challenge of thin-film silicon approaches to active matrices" * Figure 2b; page 528, colonne de droite, alinéa 2 * | 1,3 | H 01 L 21/84<br>H 01 L 29/78 |
| | --- | | |
| Y | IEEE ELECTRON DEVICE LETTERS, vol. EDL-3, no. 7, juillet 1982, pages 187-189, IEEE, New York, US; T. KODAMA et al.: "A self-alignment process for amorphous silicon thin film transistors" * Page 187, alinéa 2 - page 188, alinéa 1; figure 1 * | 1,3 | |
| | --- | | |
| A | Idem | 2 | H 01 L |
| | --- | | |
| A | JAPANESE JOURNAL OF APPLIED PHYSICS, vol. 22, supplément 22-1, 1983, pages 487-491, Tokyo, JP; M. MATSUMURA: "(Invited) amourphous silicon transistors and integrated circuits" * Page 487, paragraphe 2, lignes 1-23 * | 1,2 | |
| | ---     -/- | | |

**DOMAINES TECHNIQUES RECHERCHES (Int. Cl.4)**

H 01 L

Le présent rapport de recherche a été établi pour toutes les revendications

| Lieu de la recherche | Date d'achèvement de la recherche | Examinateur |
|---|---|---|
| LA HAYE | 04-02-1987 | ZOLLFRANK G.O. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82

## DOCUMENTS CONSIDERES COMME PERTINENTS

Page 2

| Catégorie | Citation du document avec indication, en cas de besoin, des parties pertinentes | Revendication concernée | CLASSEMENT DE LA DEMANDE (Int. Cl.4) |
|---|---|---|---|
| A | EP-A-0 139 585 (COMMISSARIAT A L'ENERGIE ATOMIQUE) * Résumé * & FR-A-2 553 579 (Cat. D) | 1 | |
| A | WO-A-8 401 239 (P. COISSARD et al.) * Résumé * | 1 | |
| | | | DOMAINES TECHNIQUES RECHERCHES (Int. Cl.4) |

Le présent rapport de recherche a été établi pour toutes les revendications

| Lieu de la recherche | Date d'achèvement de la recherche | Examinateur |
|---|---|---|
| LA HAYE | 04-02-1987 | ZOLLFRANK G.O. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO Form 1503 03 82